Europäisches Patentamt

European Patent Office

Office européen des brevets

(11) Publication number: **0 371 849**

**A1**

(12) **EUROPEAN PATENT APPLICATION**

(21) Application number: 89403202.8

(51) Int. Cl.5: **H01L 21/20**

(22) Date of filing: 21.11.89

(30) Priority: 29.11.88 US 277617

(43) Date of publication of application:
06.06.90 Bulletin 90/23

(84) Designated Contracting States:
AT BE CH DE ES FR GB GR IT LI LU NL SE

(71) Applicant: **MICROELECTRONICS CENTER OF NORTH CAROLINA**
**3021 Cornwallis Road Post Office Box 12889**
**Research Triangle Park North Carolina 27709(US)**

(72) Inventor: **Fathy, Dariush**
**8520 Barbee Lane**
**Knoxville Tennessee 37923(US)**
Inventor: **Osburn, Carlton M.**
**103 Homestead Drive**
**Cary North Carolina 27511(US)**
Inventor: **Wortman, Jimmy J.**
**Route 12 Box 192**
**Chapel Hill North Carolina 27514(US)**

(74) Representative: **Orès, Bernard et al**
**Cabinet ORES 6, Avenue de Messine**
**F-75008 Paris(FR)**

(54) **Method of forming a thin silicon layer on an insulator.**

(57) A method of forming a thin silicon layer on an insulating layer (30) by forming a thin layer of heteroepitaxial silicon (20) on a first substrate (10) other than silicon having a lattice structure which matches that of silicon. A first insulating layer is formed on the heteroepitaxial layer of silicon. A second insulating layer is formed on the surface of a second silicon substrate. The first and second insulating layers are bonded together to form a unified structure, and the first substrate is etched away, thereby obviating the etch back problems of existing techniques using homoepitaxial silicon on silicon substrates.

*FIG. 1B.*

# METHOD OF FORMING A THIN SILICON LAYER ON AN INSULATOR

## Field of the Invention

This invention relates to the fabrication of semiconductor wafers for subsequent formation into semiconductor and integrated circuit devices, and more specifically to a method of forming a thin silicon layer on an insulating layer for subsequent formation of semiconductor and integrated circuit devices in and on the thin silicon layer.

## Background of the Invention

The production of quality silicon on insulator (SOI) structures for very large scale integration applications has become an important aspect of semiconductor fabrication particularly as the dimensions of transistors and other semiconductor structures become smaller and smaller. Silicon on insulator technology allows for this shrinkage in structure while providing greater isolation between devices. This isolation is necessary because the problems associated with electrical leakage, parasitic capacitance between the structures as well as susceptibility to ionizing radiation are magnified as the size of circuits is reduced.

Various attempts have been made in the prior art to improve silicon on insulator fabrication techniques. Of particular difficulty is providing a thin and uniform monocrystalline silicon layer on the insulating layer. Great care must be taken during the thinning and removal process of the substrate so that the etching is stopped just at the silicon layer. If the etching is stopped prematurely, portions of the substrate will remain, thus preventing formation of integrated circuit devices in the silicon layer. On the other hand, if etching is allowed to proceed too far, the thin silicon layer is partially etched, and is unusable for device fabrication.

The prior art has attempted to control substrate etching using various techniques. For example, U.S. Patent No. 3,997,381 to Wanlass discloses forming a thin epitaxial silicon layer on a silicon substrate followed by forming a silicon oxide layer on the epitaxial layer. This layered device is bonded to an oxidized second substrate so that the epitaxial layer is sandwiched between the two substrates. The substrates are removed by etching to thereby expose the epitaxial layer. The electromotive force between an electrode pair immersed in the etchant solution is measured during etching, as an oxidizing agent is added, to thereby determine the proper etch end point. Another attempt to control etch end point is described in U.S. Patent No. 4,601,779 to Abernathy et al in which a buried etch-stop layer is formed in an epitaxial layer by implanting oxygen or nitrogen ions therein. An oxide layer is grown on the epitaxial portion and is used to form a bond with the oxide layer of a support wafer. After bonding, the silicon substrate is etched until the etch-stop, to expose the epitaxial layer. The etch-stop is then removed to form a thin silicon layer having a uniform thickness.

The above patents demonstrate the criticality of proper etching of the silicon substrate to expose the underlying silicon epitaxial layer, and the difficulty encountered in stopping the etch of a silicon substrate at the silicon epitaxial layer.

## Summary of the Invention

In accordance with the foregoing, it is an object of the present invention to provide a method of fabricating a silicon on insulator structure.

It is another object of the present invention to provide a method of making a silicon on insulator structure which overcomes the problem of critical etch of silicon and epitaxial silicon.

These and other objects are provided in the present invention by forming a heteroepitaxial silicon layer on a first substrate other than silicon. As is well known to those having skill in the art, the epitaxial growth process is a means of depositing a thin layer of single crystal material on a single crystal substrate. If the film is the same material as the substrate (for example silicon deposition on a silicon substrate), the process is called homoepitaxy. If, on the other hand, the deposit is made on a substrate that is chemically different (for example silicon deposition on a non-silicon substrate), the process is called heteroepitaxy.

According to the invention, a thin layer of heteroepitaxial silicon is formed on a non-silicon substrate having a lattice structure on which silicon can be grown. Examples of such non-silicon substrates are alkaline earth fluorides, for example $CaF_2$, $BaF_2$ and $SrF_2$. A first insulating layer is then formed on the layer of heteroepitaxial silicon, for example by oxidation. A second insulating layer is formed on a second substrate which may or may not be silicon, and the first and second insulating layers are bonded together to form a unified structure. The first substrate is then removed from the unified structure to expose the layer of heteroepitaxial silicon on the bonded insulating layers.

2

In the method of the present invention, the thin heteroepitaxial silicon layer is exposed by etching the first substrate. Since the first substrate is a material other than silicon, etch stop at the thin heteroepitaxial silicon layer is easy to control. In contrast with the prior art, complicated etch rate measurements or added etch stop layers are not needed to precisely control etching of the first substrate.

## Brief Description of the Drawings

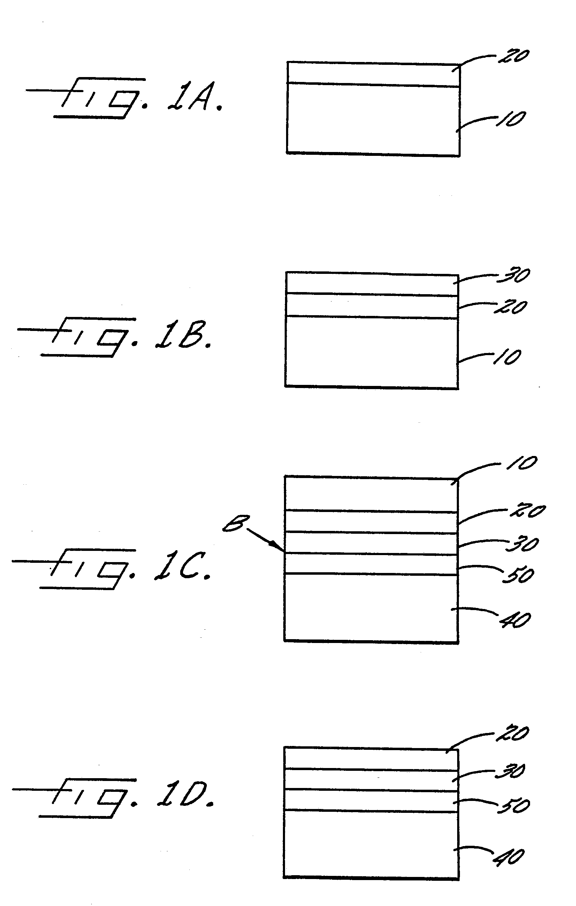

Figures 1A-1D are cross-sectional views schematically illustrating certain stages of an embodiment of the method of the present invention.

## Detailed Description of the Invention

The present invention now will be described more fully hereinafter with reference to the accompanying drawings, in which a preferred embodiment of the invention is shown. This invention can, however, be embodied in many different forms and should not be construed as limited to the embodiment set forth herein; rather, applicants provide this embodiment so that this disclosure will be thorough and complete, and will fully convey the scope of the invention to those skilled in the art.

Like characters refer to like elements throughout. For greater clarity, the thickness of the layers has been exaggerated.

Referring to Figures 1A-1D, a method of forming a thin silicon layer or film on an insulating layer to form a silicon on insulator structure, according to the present invention, is shown. In Figure 1A, a substrate 10 other than silicon has grown or formed thereon a thin crystalline silicon heteroepitaxial layer 20, for example 1 $\mu$m thick, where the thickness is chosen to satisfy the electrical device design. Non-silicon substrate 10 has a lattice structure substantially the same as the lattice structure of silicon (for example, with lattice spacings within ±2% of that of crystalline silicon) so that silicon may be heteroepitaxially grown thereon. Exemplary substrates having this lattice structure include alkaline earth fluorides selected from the group consisting of $CaF_2$, $Baf_2$ and $SrF_2$. Silicon heteroepitaxial layer 20 is formed using known techniques. Exemplary techniques for forming heteroepitaxial silicon layers are disclosed in an article by Sasski et al entitled "Molecular-Beam Epitaxy of Si on a $CaF_2/Sl(100)$ Structure" published in the Journal of Applied Physics, Vol. 59, No. 9, page 3104, May 1986, and in an article by R.F.C. Farrow et al entitled "MBE-grown fluoride films: A New Class of Epitaxial Dielectrics" published in the Journal of Vacuum Science Technology, Vol. 19, No. 3, page 415, Sept/Oct 1981, the disclosures of which are hereby incorporated herein by reference. While particular heteroepitaxial silicon deposition processes are disclosed therein, it is contemplated that other heteroepitaxial silicon formation techniques will also be useable in the present invention.

As shown in Figure 1B, an insulating layer 30, preferably 0.01 — 1$\mu$m thick, such as silicon dioxide or silicon oxide, may then be grown or formed on the thin silicon heteroepitaxial layer 20. Alternatively, it will be understood by those having skill in the art that a native oxide layer typically found on all silicon surfaces, may be employed for insulating layer 30, and that a separate insulating layer need not be grown.

Referring now to Figure 1C, a second substrate 40, which may be silicon, has an insulating layer 50, for example of silicon dioxide or silicon oxide, formed thereon, preferably 0.1-10 $\mu$m thick. Alternatively, it will be understood by those having skill in the art that a native oxide layer may be allowed to form on second substrate 40, without the need to grow a separate insulating layer. Then, insulating layer 30 is bonded to insulating layer 50 as shown at B. Typically, this is accomplished by thermally bonding insulating layers 30 and 50 together face-to-face to form a unified structure. Exemplary bonding techniques are disclosed in an article by Lasky entitled "Wafer Bonding For Silicon-On-Insulator Technologies" published in Applied Physics Letters, Vol. 48, No. 1, January 6, 1986, and in an article by Frye et al entitled "A Field-Assisted Bonding Process For Silicon Dielectric Isolation" published in Journal of the Electrochemical Society, Vol. 133, No. 8, August 1986, the disclosures of which are hereby incorporated herein by reference.

The non-silicon substrate 10 of the unified structure of Figure 1C is then substantially entirely etched away using an acid or using any other commonly available, highly selective etching process such as wet chemistry, plasma or reactive ion etching. By way of example, if $SrF_2$ is used as a non-silicon substrate 10, HCl is a suitable etchant. If $BaF_2$ or $CaF_2$ are used as a non-silicon substrate 10, and $NH_4Cl$ solution is a suitable etchant. The resulting unified silicon on insulator structure is shown in Figure 1D. Due to the dissimilarities between heteroepitaxial silicon layer 20 and substrate 10, the silicon layer is an effective etch-stop and obviates the problems associated with prior techniques. Thus, one is able to remove a thick non-silicon substrate, which is only temporarily needed to support the heteroepitaxial silicon layer during its formation and subsequent processing, while maintaining a thin and uniform silicon surface layer on an insulating layer.

It will be understood by those having skill in the art that non-silicon substrate 10 may be formed on a base substrate of silicon to provide compatibility with known silicon wafer processing. In this case, both the silicon base substrate and non-silicon substrate 10 must be etched away to form the structure of Figure 1D.

It will be seen that the non-silicon substrate of the present invention provides an effective way of forming a silicon on insulator structure which can be utilized for a plurality of semiconductor devices.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A method of forming a silicon layer on an insulating layer (30) comprising the steps of :

(a) forming a heteroepitaxial silicon layer(20) on a first substrate;

(b) forming a first insulating layer on said heteroepitaxial silicon layer;

(c) forming a second insulating layer on a second substrate;

(d) bonding together said first and second insulating layers; and

(e) removing said first substrate.

2. The method of Claim 1 wherein said first substrate (10) is a material other than silicon.

3. The method of Claim 1 wherein said first substrate is an alkaline earth fluoride.

4. The method of Claim 3 wherein said alkaline earth fluoride is crystalline alkaline earth fluoride.

5. The method of Claim 4 wherein said alkaline earth fluoride is selected from the group consisting of: $CaF_2$, $BaF_2$ and $SrF_2$.

6. The method of Claim 1 wherein said first substrate (10) is a crystalline material other than silicon, having a crystal structure which matches that of crystalline silicon.

7. The method of Claim 1 wherein step (b) comprises the step of growing a silicon dioxide layer on the heteroepitaxial silicon layer.

8. The method of Claim 1 wherein step (c) comprises the step of growing a silicon dioxide layer on said second substrate.

9. The method of Claim 1 wherein step (b) comprises the step of allowing a native silicon dioxide layer to form on the heteroepitaxial silicon layer.

10. The method of Claim 1 wherein step (b) comprises the step of allowing a native silicon dioxide layer to form on said second substrate.

11. The method of Claim 1 wherein said second substrate is crystalline silicon.

12. The method of Claim 1 wherein said bonding step (d) comprises the step of thermally bonding said first and second insulating layers.

13. The method of Claim 1 wherein said removing step (e) comprises the step of etching said first substrate with an etchant which does not etch silicon to thereby etch said first substrate and stop at said heteroepitaxial silicon layer.

14. The method of Claim 1 wherein said first substrate is formed on a base substrate of silicon.

15. A method of forming a silicon layer on an insulating layer comprising the steps of:

(a) forming a heteroepitaxial silicon layer on a first substrate of crystalline alkaline earth fluoride;

(b) forming a first oxide layer on said heteroepitaxial silicon layer;

(c) forming a second oxide layer on a silicon substrate;

(d) thermally bonding said first and second oxide layers; and

(e) etching said first substrate to expose said heteroepitaxial silicon layer.

16. The method of Claim 15 wherein said first substrate is selected from the group consisting of: $CaF_2$, $BaF_2$ and $SrF_2$.

17. A method of forming a silicon layer on an insulating layer comprising the steps of:

(a) forming a layer of crystalline silicon on a first substrate other than silicon;

(b) forming a first insulating layer on said first substrate;

(c) forming a second insulating layer on a second substrate;

(d) bonding together said first and second insulating layers; and

(e) removing said first substrate.

18. The method of Claim 17 wherein said first substrate has a crystalline structure upon which crystalline silicon may be formed.

19. The method of Claim 17 wherein said first substrate has a crystalline structure which matches that of silicon.

Fig. 1A.

Fig. 1B.

Fig. 1C.

Fig. 1D.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | US-A-3 997 381 (WANLASS) --- | | H 01 L 21/20 |
| A | US-A-4 226 649 (DAVEY et al.) --- | | |
| A | PATENT ABSTRACTS OF JAPAN, vol. 8, no. 229 (E-273)[1666], 20th October 1984; & JP-A-59 111 321 (ASAHI KASEI KOGYO K.K.) 27-06-1984 --- | | |
| A | PATENT ABSTRACTS OF JAPAN, vol. 7, no. 247 (E-208)[1392], 2nd November 1983; & JP-A-58 135 628 (ASAHI KASEI KOGYO K.K.) 12-08-1983 --- | | |
| D,A | JOURNAL OF APPLIED PHYSICS, vol. 59, no. 9, 1st May 1986, pages 3104-3109, American Institute of Physics, NY, US; M. SASAKI et al.: "Molecular-beam epitaxy of Si on a CaF2/Si (100) structure" ----- | | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 03-03-1990 | GELEBART Y.C.M. |